# EUROPEAN PATENT APPLICATION

(11) **EP 2 650 903 A1**
(43) Date of publication of application: **16.10.2013**
(21) Application number: 13163240.8
(22) Date of filing: 10.04.2013
(51) Int. Cl.: H01K 1/14, H01L 21/67, H05B 3/00

(54) **Filament lamp for heating**

(30) Priority: 11.04.2012 JP 2012089813
(71) Applicant: Ushio Denki Kabushiki Kaisha, Tokyo 100-8150 (JP)
(72) Inventor: Ueshima, Yukio, Himeji-shi Hyogo 6710224 (JP); Nishikawa, Masaaki, Himeji-shi Hyogo 6710224 (JP)
(74) Representative: Price, Christopher

(57) **Abstract**

Disclosed herein is a filament lamp for heating a disk-shaped workpiece in such a way that the filament lamp rotates relative to the workpiece and radiates light thereonto. The filament lamp can uniformly heat the overall area of the workpiece despite having a simple structure. The filament lamp extends, with respect to a radial direction of a circular radiation area corresponding to the workpiece, from a central portion of the radiation area to a perimeter portion thereof. The filament lamp includes an inner emitting part which extends in the radial direction from the central portion of the radiation area to the perimeter portion thereof; and an outer emitting part which extends in a circumferential direction on the perimeter portion of the radiation area. A circumferential component of the outer emitting part per unit length is longer than a circumferential component of the inner emitting part per unit length.

## Description

### BACKGROUND OF THE INVENTION

### 1. Technical Field

The present invention relates generally to filament lamps for heating disk-shaped workpieces and, more particularly, to a filament lamp for heating a semiconductor wafer in such a way that the filament lamp and the semiconductor wafer rotate relative to each other.

### 2. Description of the Related Art

As is well known to those skilled in the art, filament lamps are widely used as heating sources for heat treatment such as annealing, oxidation, diffusion when forming a film such as an oxide film, a metal film or a semiconductor film on a substrate, e.g. a semiconductor wafer, or the like.

A heating apparatus using such a heating source is generally configured such that the heating source heats a workpiece when the workpiece is rotating. This technique was disclosed in Japanese Patent Laid-open Publication No. 2010-086985 (Patent document 1).

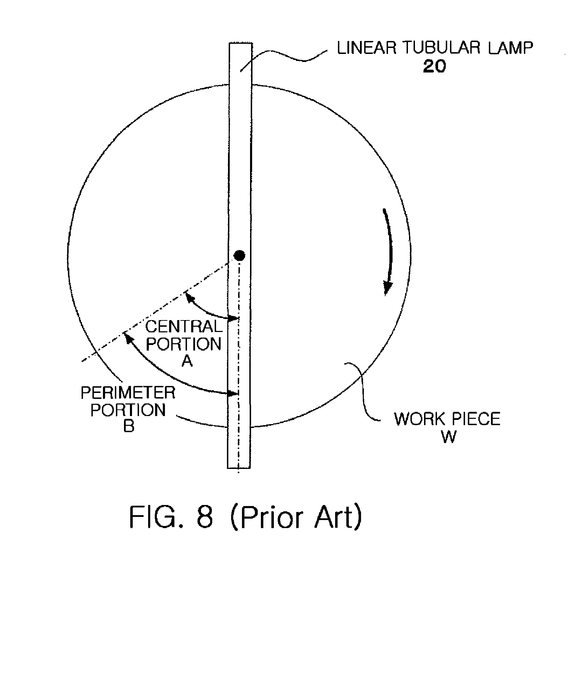

However, the conventional heating apparatus uses a linear tubular lamp, which may easily cause nonuniformity in light radiation between a central portion and a perimeter portion of a workpiece. FIG. 8 shows this nonuniformity phenomenon. When a linear tubular lamp 20 radiates light onto a workpiece W that is rotating, a light radiation rate is different between a central portion A and a perimeter portion B of the workpiece W. As a result, the central portion A of the workpiece W is heated to a high temperature, while the perimeter portion B thereof is heated to a lower temperature. As such, if the overall area of the workpiece W is not uniformly heated, it is impossible to reliably and uniformly process the workpiece. This causes a defective product.

In an effort to overcome the above problem, a heating source having a plurality of annular lamps was proposed in Japanese Patent Laid-open Publication No. 11-176389 (Patent document 2). The structure of this technique is illustrated in FIG. 9. Referring to FIG. 9, the annular lamps 30, 31, 32 and 33 are concentrically arranged. The annular lamps 30, 31, 32 and 33 are individually controlled to uniformly heat the overall area of a workpiece.

However, this technique requires the several annular lamps to be arranged, thus making the electrical wiring very complex.

Furthermore, given the fact that heat is dissipated from the perimeter portion of the workpiece to the outside, separate heating temperature controls are required for the lamp that is disposed on the perimeter portion and the lamp that is disposed on the central portion of the workpiece. Therefore, the structure of a control device is complicated, and it becomes more difficult to control the heating temperature.

### [Prior art document]

### [Patent document]

Japanese Patent Laid-open Publication No. 2010-086985
Japanese Patent Laid-open Publication No. Heisei. 11-176389

### SUMMARY OF THE INVENTION

Accordingly, the present invention has been made keeping in mind the above problems occurring in the prior art, and an object ofthe present invention is to provide a filament lamp for heating a disk-shaped workpiece in such a way that the filament lamp radiates light onto the disk-shaped workpiece while the filament lamp and the disk-shaped workpiece rotate relative to each other, and a heating apparatus using the filament lamp, and, particularly, to a structure that enables heating temperature to be maintained uniformly on a central portion and a perimeter portion of the disk-shaped workpiece so that the workpiece can be uniformly heated without separately controlling the temperature of the filament lamp.

In order to accomplish the above object, in an aspect, the present invention provides a filament lamp for heating a disk-shaped workpiece in such a way that the filament lamp radiates light onto the disk-shaped workpiece while the filament lamp and the disk-shaped workpiece rotate relative to each other, the filament lamp including: a filament extending, with respect to a radial direction of a circular radiation area corresponding to a disk-shaped workpiece, from a central portion of the radiation area to a perimeter portion thereof, the filament comprising: an inner emitting part extending in the radial direction from the central portion of the radiation area to the perimeter portion thereof, and an outer emitting part extending in a circumferential direction on the perimeter portion of the radiation area, wherein a circumferential component of the outer emitting part per unit length is longer than a circumferential component of the inner emitting part per unit length.

The outer emitting part may include an arc-shaped portion extending in the circumferential direction.

An inner end of the inner emitting part may extend towards a position displaced from a center ofthe circular radiation area.

The filament lamp may comprise a pair of filament lamps integrated with each other by connecting the inner emitting parts ofthe filament lamps to each other.

The filament may include an emitting part and a non-emitting part.

In a filament lamp for heating a disk-shaped workpiece according to the present invention, the circumferential component length of the filament lamp is comparatively short on an inner emitting part of the filament lamp that corresponds to a central portion of the disk-shaped workpiece where a scanning speed of the lamp is low due to a low rotational displacement rate ofthe workpiece. On the other hand, the circumferential component length of the filament lamp is comparatively long on an outer emitting part of the filament lamp that corresponds to a perimeter portion of the workpiece where the rotational displacement rate ofthe workpiece is high. Therefore, a rate at which the lamp radiates light onto the workpiece is uniform over the entire area of the workpiece. Thereby, the entirety of the workpiece can be heated uniformly.

Furthermore, the outer emitting part has an arc-shaped portion which extends circumferentially, thus increasing a heating rate on the perimeter portion of the workpiece that is prone to losing heat. Thereby, the temperature uniformity ofthe workpiece can be more reliably ensured.

Moreover, the filament of the filament lamp may include an emitting part and a non-emitting part. In this case, the temperature ofthe workpiece can be more precisely controlled to be uniform.

### BRIEF DESCRIPTION OF THE DRAWINGS

The above and other objects, features and advantages of the present invention will be more clearly understood from the following detailed description taken in conjunction with the accompanying drawings, in which:

FIG. 1 illustrates an embodiment of a filament lamp for heating according to the present invention;

FIG. 2 is a schematic view of FIG. 1;

FIG. 3 shows another embodiment of the filament lamp for heating according to the present invention;

FIG. 4 is a further embodiment of the filament lamp for heating according to the present invention;

FIG. 5 illustrates yet another embodiment of the filament lamp for heating according to the present invention;

FIG. 6 illustrates an embodiment of a heating apparatus according to the present invention;

FIG. 7 is a view showing an example of arrangement of lamps in the heating apparatus according to the present invention;

FIG. 8 is a plan view of a conventional technique; and

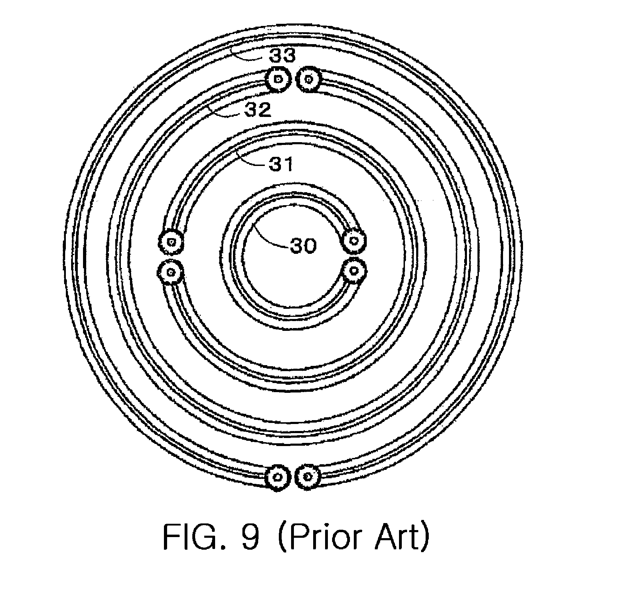

FIG. 9 illustrates another conventional technique.

### DESCRIPTION OF THE PREFERRED EMBODIMENTS

Reference now should be made to the drawings, throughout which the same reference numerals are used to designate the same or similar components.

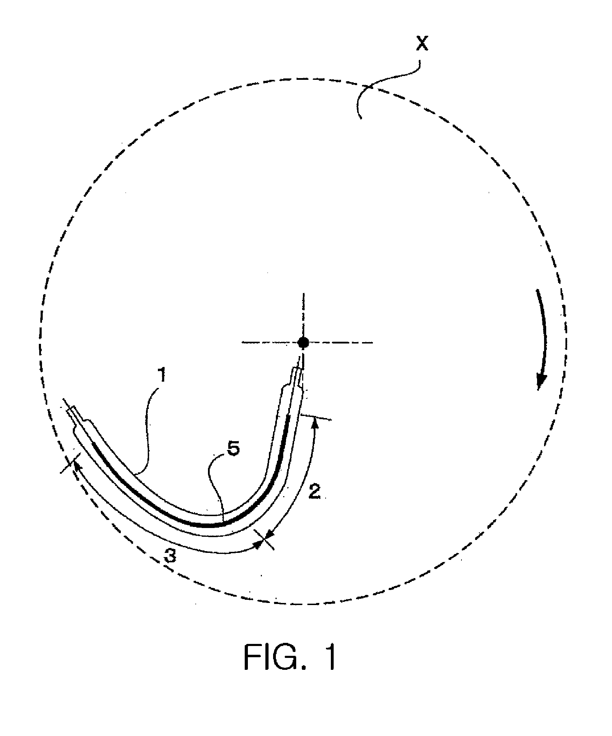

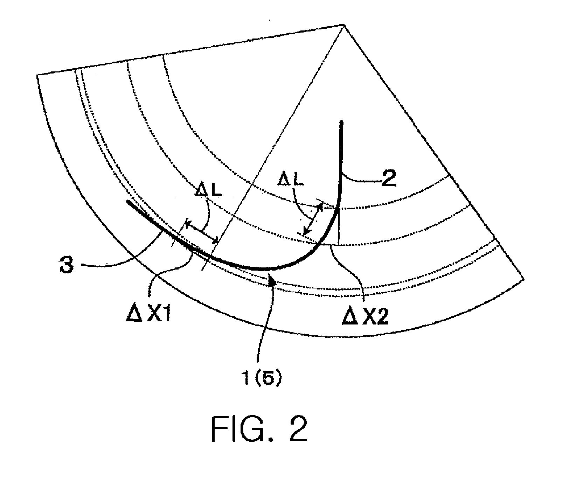

FIG. 1 illustrates a filament lamp 1 according to the present invention. FIG. 2 is a schematic view ofthe filament lamp 1.

As shown in FIG. 1, the filament lamp 1 is a lamp which radiates light onto a disk-shaped workpiece to heat it. Either the lamp or the workpiece rotates when the lamp is radiating light onto the workpiece and heating it.

The filament lamp 1 includes a filament 5 therein. The filament 5 extends, with respect to a radial direction of a circular radiation area X corresponding to the disk-shaped workpiece, from the central portion of the radiation area X to the perimeter thereof The filament 5 includes an inner emitting part 2 which extends in the radial direction from the central portion of the radiation area X to the perimeter thereof, and an outer emitting part 3 which extends in a circumferential direction on the perimeter ofthe radiation area X.

As shown in FIG. 2, the filament lamp 1 is configured such that a circumferential component (ΔX1) of the outer emitting part 3 per unit length (ΔL) is longer than a circumferential component (ΔX2) ofthe inner emitting part 2 per unit length (ΔL).

The circumferential length (ΔX) does not necessarily have to vary from an inner end of the filament 5 to an outer end thereof, that is, over the entire length of the filament 5. For example, the inner emitting part 2 may linearly extend a predetermined length from the inner end thereof in the radial direction.

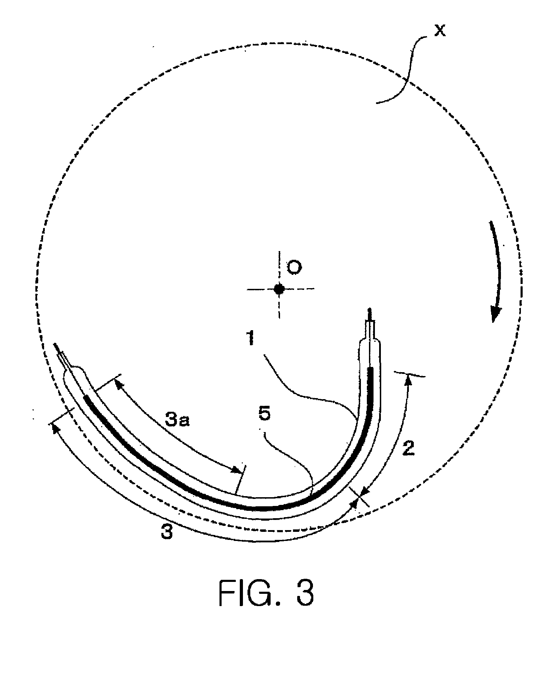

FIG. 3 illustrates another embodiment. In this embodiment, the inner end of the inner emitting part 2 is oriented towards a position displaced from the center O of the circular radiation area X, rather than being oriented towards the center O.

Further, this drawing also illustrates an embodiment in which the outer emitting part 3 of the filament lamp 1 includes an arc-shaped portion 3a which extends a predetermined length from the outer end of the outer emitting part 3 to a predetermined portion thereof in the circumferential direction. As a result of this structure, a heating rate can be increased on the perimeter portion of the workpiece that is prone to losing heat, thereby preventing the temperature ofthe perimeter portion from being undesirably lowered.

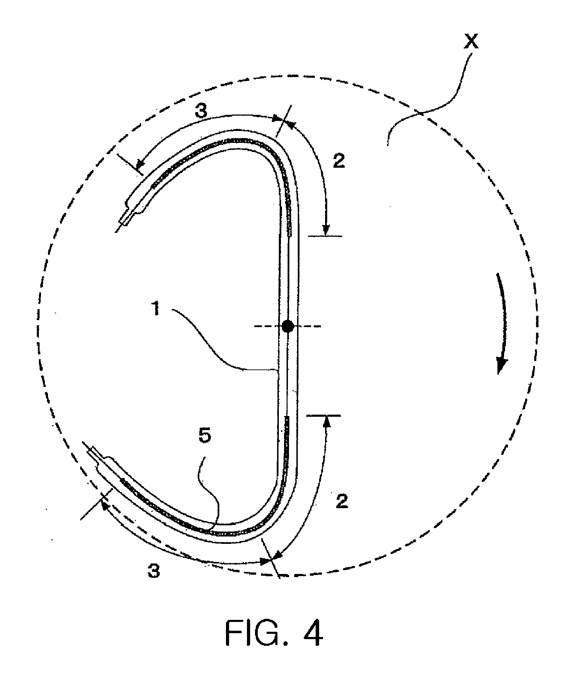

FIG. 4 illustrates a further embodiment where a pair of filament lamps 1 of FIG. 1 are integrated with each other in such a way that their inner emitting parts 2 are connected to each other.

In this drawing, although both outer emitting parts 3 have been illustrated as extending in directions in which they face each other, the outer emitting parts 3 may extend in the same circumferential direction so that the overall filament lamp has an approximate S shape.

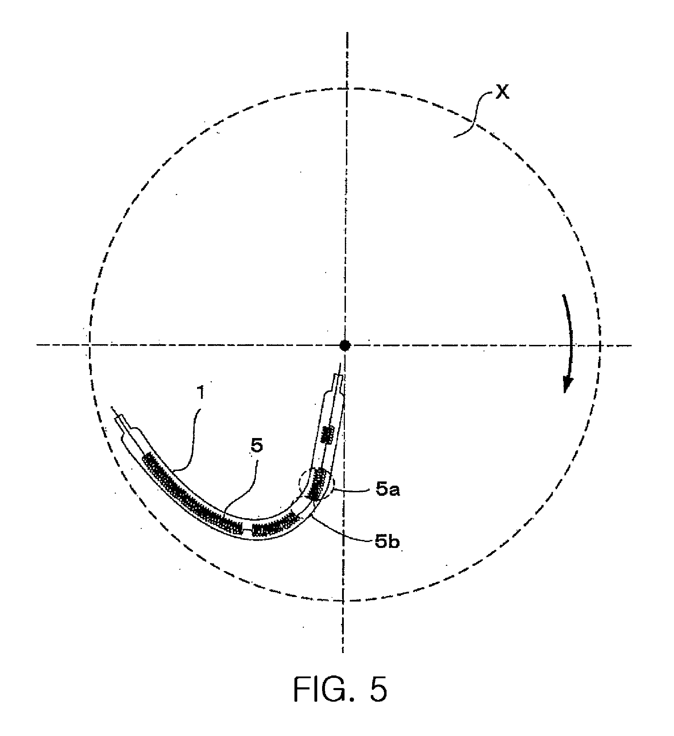

FIG. 5 illustrates yet another embodiment where a filament 5 provided in a filament lamp 1 includes an emitting part 5a and a non-emitting part 5b. In this embodiment, the temperature uniformity can be more precisely controlled by appropriately adjusting an area ratio between the emitting part 5a and the non-emitting part 5b.

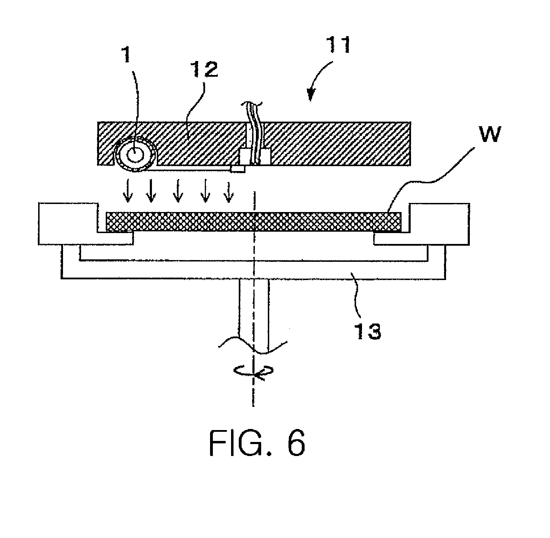

FIG. 6 illustrates a heating apparatus 10 provided with the above-stated filament lamp 1 for heating.

The filament lamp 1 is installed in a lower surface of a lamp holder 12, thus forming a lamp unit 11.

A workpiece stage 13 is rotatably disposed below the lamp unit 11. A workpiece W is placed on the workpiece stage 13.

Of course, the heating apparatus 10 may be configured such that the lamp holder 11 rotates rather than the workpiece stage 13 rotating.

Furthermore, although the lamp unit 11 has been illustrated as being disposed above the workpiece W, it may be provided in an inverted arrangement, in other words, the lamp unit 11 may be disposed below the workpiece stage 13 in such a way that light is radiated onto a lower surface ofthe workpiece W.

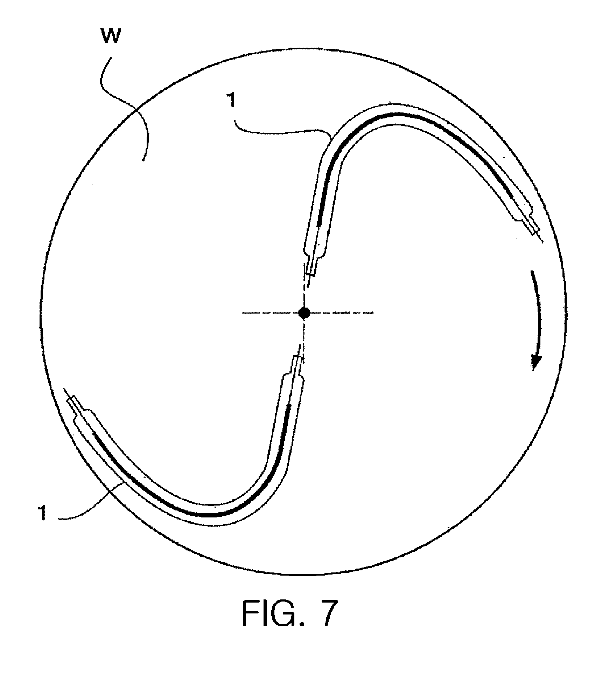

The heating apparatus 10 may be provided with any one ofthe filament lamps 1 of FIG. 1 through 4. Alternatively, as shown in FIG. 7, a plurality of filament lamps 1 may be provided.

In other words, a plurality of filament lamps 1 may be arranged at predetermined intervals in the circumferential direction ofthe workpiece W. In this embodiment, two filament lamps 1 are provided.

As described above, a filament lamp for heating according to the present invention extends, with respect to a radial direction of a circular radiation area corresponding to a disk-shaped workpiece, from the central portion of the radiation area to the perimeter thereof. Further, the filament lamp includes an inner emitting part which extends in the radial direction from the central portion of the radiation area to the perimeter thereof, and an outer emitting part which extends in a circumferential direction on the perimeter of the radiation area. In addition, the filament lamp is configured such that a circumferential component ofthe outer emitting part per unit length is longer than a circumferential component of the inner emitting part per unit length. Thereby, an area with which the lamp covers the workpiece is comparatively large on the perimeter portion of the workpiece where a rotational displacement rate is high. Therefore, the temperature uniformity on the overall workpiece can be ensured by the single filament lamp.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A filament lamp (1) for heating a disk-shaped workpiece (W) in such a way that the filament lamp (1) radiates light onto the disk-shaped workpiece (W) while the filament lamp (1) and the disk-shaped workpiece (W) rotate relative to each other, the filament lamp (1) comprising:
a filament (5) extending, with respect to a radial direction of a circular radiation area corresponding to a disk-shaped workpiece (W), from a central portion of the radiation area to a perimeter portion thereof, the filament (5) comprising: an inner emitting part (2) extending in the radial direction from the central portion of the radiation area to the perimeter portion thereof; and an outer emitting part (3) extending in a circumferential direction on the perimeter portion of the radiation area,
wherein a circumferential component of the outer emitting part (3) per unit length is longer than a circumferential component ofthe inner emitting part (2) per unit length.

2. The filament lamp (1) as set forth in claim 1, wherein the outer emitting part (3) comprises an arc-shaped portion (3a) extending in the circumferential direction.

3. The filament lamp (1) as set forth in claim 1, wherein an inner end of the inner emitting part (2) extends towards a position displaced from a center ofthe circular radiation area.

4. The filament lamp (1) as set forth in claim 1 comprising a pair of filament lamps integrated with each other by connecting the inner emitting parts of the filament lamps to each other.

5. The filament lamp (1) as set forth in any one of claims 1 through 4, wherein the filament (5) comprises an emitting part (5a) and a non-emitting part (5b).
